# FASCICULE DE BREVET EUROPEEN

(11) **EP 0 750 398 B1**
(45) Date de publication et mention de la délivrance du brevet: **09.01.2002**
(21) Numéro de dépôt: 96401349.4
(22) Date de dépôt: 20.06.1996
(51) Int. Cl.: H03M 5/12, H04L 25/49

(54) **Codeur/décodeur Manchester**
Manchester Koder/Dekoder
Manchester encoder/decoder

(30) Priorité: 22.06.1995 FR 9507491
(43) Date de publication de la demande: 27.12.1996
(73) Titulaire: FRANCE TELECOM, 75015 Paris (FR); LA POSTE, 92777 Boulogne Billancourt Cédex (FR)
(72) Inventeur: Abou Hassan, Salman, 14000 Caen (FR)
(74) Mandataire: Dubois-Chabert, Guy

(56) Documents cités:
- EP-A- 0 486 072
- DE-A- 4 214 966
- FR-A- 2 644 952
- US-A- 4 918 296
- APPLIED OPTICS, vol. 31, no. 12, Avril 1992, NEW YORK, US, pages 2001-2004, XP000265454 A.J. AL-SAMMAK ET AL.: "Manchester encoder-decoder for optical data communication links"
- ELEKTRONIK, no. 9, 30 Avril 1991, MÜNCHEN, DE, pages 118-120, XP000228506 R. SANDER ET AL.: "Asics für die Objekterkennung"
- ELECTRONIC DESIGN, vol. 34, no. 7, Mars 1986, HASBROUCK HEIGHTS, US, pages 105-111, XP002012159 R. DUNCAN ET AL.: "Programmable logic places a gate-array foundry at every designer's fingertips"

## Description

### Domaine technique

La présente invention conceme un codeur/décodeur Manchester.

### Etat de la technique antérieure

Le domaine de l'invention est celui des cartes sans contact de tous types : cartes de proximité, cartes à moyenne et longue distances, cartes monofréquences téléalimentées ou alimentées sur pile et cartes multifréquences téléalimentées. Le domaine de l'invention est également celui des étiquettes électroniques.

Les protocoles d'échange utilisés dans les transmissions entre une carte sans contact et son lecteur procèdent à un codage de l'information transmise. L'objectif essentiel du codage est d'éviter la transmission d'une suite de bits à "0". Dans ce cas, le code Manchester est le code le plus utilisé. Mais ce code introduit une difficulté supplémentaire de réalisation qui réside dans le décodage des données, que ce soit du côté carte ou du côté lecteur. Si la réalisation du codage Manchester est triviale, elle peut être réalisée facilement avec des fonctions du type "OU EXCLUSIF". Celle du décodage est beaucoup plus complexe et nécessite l'introduction de lignes de retard dans la chaîne de décodage. Un soin particulier doit être porté à la synchronisation des horloges de transmission du côté carte ainsi que du côté lecteur, ceci dans les deux sens de transmission.

Un document de l'art antérieur, la demande DE-A-4 214 966, décrit un système de conversion de code qui permet l'émission de données en code non retour à zéro, et en réception la conversion des données reçues en code Manchester en données codées en non retour à zéro, en utilisant des circuits de codage et de décodage. Un contrôleur à l'extrémité réception reçoit les données de préambule fournies par le codeur au travers d'une ligne de données en provenance du décodeur pour permettre une identification précise des début et fin de données.

L'objet de l'invention est de proposer un dispositif qui assure le codage/décodage type Manchester, l'innovation résidant dans la partie décodage, ce dispositif assurant également la génération de l'horloge de transmission et sa synchronisation, l'horloge de transmission étant générée à partir de la fréquence HF remise en forme dans une tête analogique.

### Exposé de l'invention

Le codeur/décodeur Manchester de l'invention comprend les modules suivants :
- un module de génération du signal de synchronisation : ce module a une importance primordiale. C'est lui qui donne le signal de départ des horloges, spécialement l'horloge de décodage ; ce qui permet au décodeur de se repérer par rapport à un instant de référence connu T0 ;
- un module de synchronisation et génération des horloges : ce module génère les horloges de transmission/codage, de décodage et une horloge basse fréquence. Ces horloges servent à l'intérieur du codeur/décodeur. Elles possèdent aussi des sorties à l'extérieur pour synchroniser les autres circuits fonctionnant avec le codeur/décodeur (réception, émission, etc...) ;
- un module de décodage : le décodage Manchester est assuré en grande partie par le précédent module qui génère une horloge de décodage précise. Les fronts de cette horloge sont toujours placés au même endroit dans un bit reçu. Il en résulte un décodeur très simple qui est réduit à une bascule pilotée par l'horloge de décodage. En effet, le décodage est un simple échantillonnage du signal d'entrée des données codées Manchester pendant la phase de réception et destinées à être décodées, effectué au front montant de l'horloge (au front descendant pour un code indirect) ;
- un module de codage : ce module réalise une fonction "OU EXCLUSIF" entre le signal d'entrée des données destinées à être codées en code Manchester pendant la phase d'émission et l'horloge de transmission,
dans lequel ledit codeur/décodeur fonctionne avec l'horloge de codage et l'horloge de décodage à la fréquence de transmission définie, par exemple 9600 bauds, la première horloge étant générée à partir du signal HF (haute fréquence) reçu en utilisant un diviseur de fréquence, cette horloge étant resynchronisée sur le signal codé lors de la réception, la mise en phase étant effectuée sur un premier front du signal reçu, qui est considéré comme instant zéro pour la création de la seconde horloge, la seconde horloge étant également générée à partir du signal HF reçu, en utilisant le même diviseur de fréquence que celui qui génère l'horloge de codage, cette horloge de décodage présentant un retard déterminé, par exemple de ¼ de bit, par rapport à l'horloge de codage.

Il est caractérisé en ce que les seules données à décoder suffisent pour le décodage, aucune information sur l'horloge de codage n'étant nécessaire pour le décodage.

Le décodage se fait en échantillonnant la ligne d'entrée au front montant de l'horloge de décodage. Dans le cas d'un code Manchester indirect le retard peut être de 3T/4.

Le codeur/décodeur de l'invention a été réalisé sous forme d'une macro-cellule intégrée dans un ASIC ("Application-Specific Integrated Circuit" ou circuit intégré spécifique). Outre le module objet de l'invention, l'ASIC intègre la tête analogique, une mémoire par exemple de type EEPROM ("Electrically Erasable Programmable Read-Only Memory" ou mémoire morte programmable effaçable électriquement) et une partie logique qui gère le protocole d'émission/réception et de lecture/écriture dans la mémoire. Cet ASIC a été utilisé dans deux applications : étiquette électronique et carte sans contact.

Le module de l'invention a également été réalisé sous forme d'un circuit programmable (FPGA : "Field Programmable Gate Array" ou composant programmable). Sous cette forme il peut être utilisé côté lecteur.

Le codeur/décodeur de l'invention présente un intérêt certain pour tout système sans contact utilisant un codage biphase des données. Ses points forts sont :
- il est complètement numérique. Sa réalisation est très simple. La génération de l'horloge de transmission et le décodage utilisent les mêmes ressources. Il en résulte un module très compact et de faible consommation ;
- la carte sans contact (ou l'étiquette électronique) est toujours synchronisée avec le lecteur. C'est le principe même du système de décodage ;
- il est simple d'utilisation. Il peut être utilisé aussi bien avec un microprocesseur qu'avec de la logique câblée, des deux côtés du système (lecteur et carte).

### Brève description des dessins

- La figure 1 représente le codeur/décodeur de l'invention ;
- la figure 2 représente un chronogramme des horloges de codage et de décodage.

### Exposé détaillé de modes de réalisation

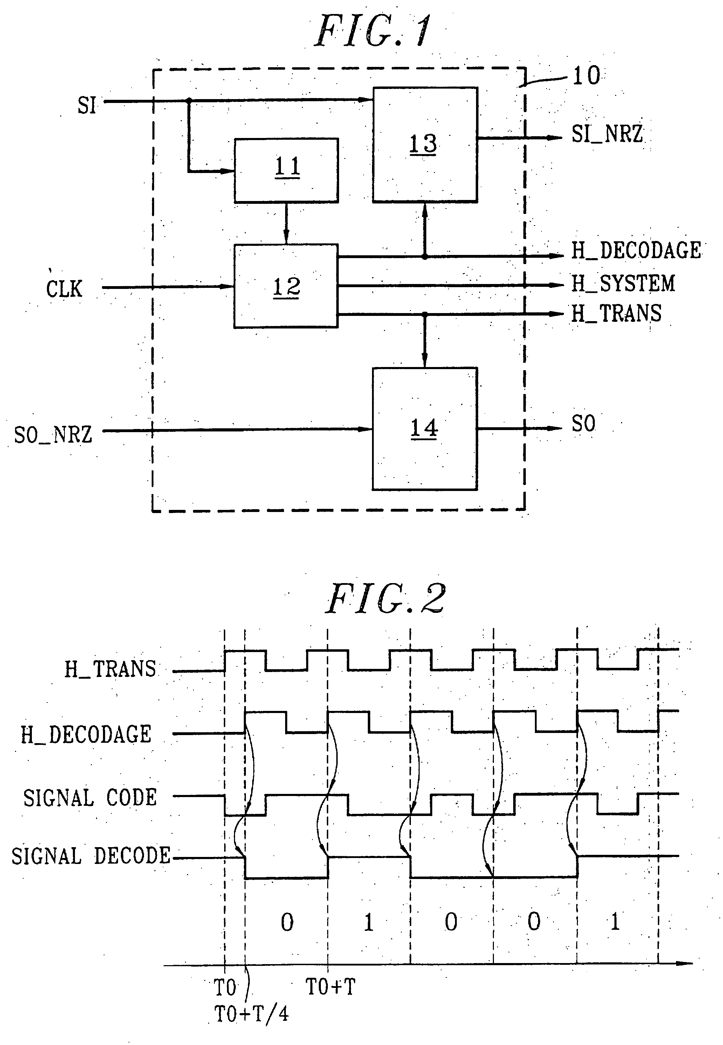

La figure 1 montre une vue schématique du codeur/décodeur de l'invention. C'est un dispositif 10 avec huit entrées/sorties:
- une horloge CLK à la fréquence du signal radiofréquence ou RF, émis par le lecteur. Ce signal est le résultat de la récupération/mise en forme du signal RF par une interface analogique. La fréquence de l'horloge CLK est de 4,9 MHz dans un cas considéré à titre d'exemple. Cette fréquence pourrait être beaucoup plus élevée mais aussi plus basse. La limitation de fréquence n'est pas due à la réalisation du codeur/décodeur de l'invention. Cette horloge CLK sert à générer toutes les autres horloges utilisées dans le codeur/décodeur de l'invention ;
- une entrée SI des données codées Manchester pendant la phase de réception et destinées à être décodées ;
- une entrée SO_NRZ des données destinées à être codées en code Manchester pendant la phase émission;
- une sortie SI_NRZ des données reçues sur l'entrée SI et décodées par le codeur/décodeur de l'invention ;
- une sortie SO des données reçues sur l'entrée SO_NRZ et codées Manchester par le codeur/décodeur de l'invention ;
- une horloge H_SYSTEM générée à partir de l'horloge CLK et qui sert au fonctionnement du reste de la logique. La fréquence de cette horloge est basse par rapport à celle de l'horloge CLK, ce qui améliore le bilan énergétique du circuit (circuit réalisé en technologie CMOS dont la consommation augmente avec la fréquence). Dans le cas considéré la fréquence est de 150 Khz;
- une horloge H_TRANS de transmission générée à partir de l'horloge H_SYSTEM. Elle sert à rythmer la vitesse de transmission (9600 bauds dans le cas considéré) ainsi qu'au codage Manchester ;
- une horloge H_DECODAGE de décodage Manchester générée à partir de l'horloge H_SYSTEM (9600 Hz dans le cas considéré).

La vitesse de transmission du codeur/décodeur de l'invention n'est pas limitée à 9600 bauds. Ainsi le codeur/décodeur peut être utilisé avec la palette de vitesses de transmission les plus utilisées (9600, 19 200 ou toute autre vitesse).

Comme représenté sur la figure 1 le codeur/décodeur Manchester de l'invention comprend les modules suivants :
- Un module 11 de génération du signal de synchronisation : ce module a une importance primordiale. C'est lui qui donne le signal de départ des horloges, spécialement l'horloge de décodage H_DECODAGE, ce qui permet au décodeur de se repérer par rapport à un instant de référence connu T0.

Pour générer un signal de synchronisation (RAZ_H_9600), ce bloc écoute la ligne SI en permanence. dès qu'il détecte une transition de "1" à "0", il déclenche une minuterie et se remet en attente pendant par exemple 1 ms. La première transition de "1" à "0" arrivant après 1 ms lui servira comme instant T0.

Cette période d'attente de 1 ms permet d'éviter la synchronisation sur des transitions parasites ; ce délai d'attente est modifiable, il peut être plus ou moins grand, ceci selon les performances du système de démodulation du point de vue de l'établissement d'un signal stable.
- Un module 12 de synchronisation et génération des horloges: ce module génère les horloges de transmission/codage, de décodage et une horloge basse fréquence. Ces horloges servent à l'intérieur du codeur/décodeur. Elles possèdent aussi des sorties à l'extérieur pour synchroniser les autres circuits fonctionnant avec le codeur/décodeur (réception, émission, etc...) :
   - l'horloge H_SYSTEM obtenue à partir de l'horloge CLK par un simple compteur diviseur (division par 32 dans notre cas): c'est une horloge permanente qui démarre directement après l'initialisation par un signal RESET ;
   - L'horloge de transmission H_TRANS : elle fixe la vitesse de transmission et sert au codage Manchester. Elle est générée à partir de l'horloge H_SYSTEM par un compteur diviseur (diviseur par 16) mis à zéro par le signal de synchronisation généré par le premier module 11 (RAZ_H_9600 = "1" force le compteur à 0 ; le compteur est libéré dès que RAZ_H_9600 passe à "0"). L'horloge H_TRANS fonctionne alors à partir de l'instant de départ T0, elle est resynchronisée à chaque impulsion du signal RAZ_H_9600;
   - L'horloge de décodage H_DECODAGE: elle sert uniquement au décodage Manchester. Elle est générée de la même manière que H_TRANS et avec le même compteur. Elle est bloquée en même temps que l'horloge H_TRANS lors d'une impulsion RAZ_H_9600 = "1", mais démarre avec un retard par rapport à l'horloge H_TRANS quand le signal RAZ_H_9600 passe à "0". Ce retard est de 1/4 de la durée d'un bit dans le cas du code Manchester direct ; il est de 3/4 de la durée d'un bit dans le cas du code Manchester indirect (la durée d'un bit à 9600 bauds est de 104 µs). Le délai qui sépare deux fronts montants (descendants) est toujours le même. Un glissement de fréquence de l'horloge H_TRANS affecte également l'horloge H_DECODAGE dans les mêmes proportions ;
   - l'horloge CLK est disponible dans le lecteur ainsi que dans la carte. Si le codeur/décodeur est utilisé des deux côtés, l'horloge de transmission H_TRANS, étant générée de la même manière à partir du signal CLK, est synchrone dans les deux dispositifs. Dans le cas où le codeur/décodeur est utilisé uniquement côté carte, l'horloge H_TRANS de la carte est asservie sur celle du lecteur. Dans les deux cas la synchronisation côté codeur/décodeur est toujours assurée.
- Un module 13 de décodage : le décodage Manchester est assuré en grande partie par le précédent module qui génère une horloge de décodage H_DECODAGE précise. Les fronts de cette horloge sont toujours placés au même endroit dans un bit reçu. Il en résulte un décodeur très simple qui est réduit à une bascule pilotée par l'horloge de décodage. En effet, le décodage est un simple échantillonnage du signal SI d'entrée des données codées Manchester pendant la phase de réception et destinées à être décodées, effectué au front montant de l'horloge (au front descendant pour un code indirect).
- Un module 14 de codage : ce module réalise une fonction "OU EXCLUSIF" entre le signal SO_NRZ d'entrée des données destinées à être codées en code Manchester pendant la phase d'émission et l'horloge de transmission H_TRANS.

Le codeur/décodeur 10 de l'invention fonctionne avec deux horloges à la fréquence de transmission définie, par exemple 9600 bauds: une horloge de codage et une horloge de décodage.

La première horloge est utilisée pour le codage (lors de l'émission). Elle est générée à partir du signal HF en utilisant un diviseur de fréquence. Cette horloge est resynchronisée sur le signal codé lors de la réception. La mise en phase est effectuée au premier front descendant du signal reçu, qui est considéré comme instant zéro (T0) pour la création de la deuxième horloge.

L'horloge de décodage est également générée à partir du signal HF, en utilisant le même diviseur de fréquence qui génère l'horloge de codage, cette horloge présentant un retard déterminé, par exemple de 1/4 de bit par rapport à l'horloge de codage. la mise en phase de cette horloge s'effectue à l'instant T0 + T/4. Le déccdage se fait en échantillonnant la ligne d'entrée au front montant de l'horloge de décodage comme représenté sur la figure 2.

La réalisation du codeur/décodeur de l'invention est très simple, ce qui fait son originalité et son intérêt.

Le codeur/décodeur de l'invention a été réalisé avec le langage de description de matériel VHDL ("Very High Speed Integrated Circuit-Hardware Description Language" ou langage de description matériel de très haut niveau). Son comportement a été simulé et son fonctionnement vérifié. La réalisation au niveau matériel a été effectuée par une synthèse dans une librairie de "standardcells". Le découpage en modules de la figure 1 correspond exactement au découpage fonctionnel décrit en VHDL. La description en langage VHDL est donnée en annexe.

Le codeur/décodeur de l'invention a été réalisé sous forme d'une macro-cellule intégrée dans un ASIC. Outre le module objet de l'invention, l'ASIC intègre la tête analogique, une mémoire par exemple de type EEPROM et une partie logique qui gère le protocole d'émission/réception et de lecture/écriture dans la mémoire. Cet ASIC a été utilisé dans deux applications : étiquette électronique et carte sans contact.

Le module de l'invention a également été réalisé sous forme d'un circuit programmable (FPGA). Sous cette forme il peut être utilisé côté lecteur.

Dans un exemple de réalisation le codeur/décodeur de l'invention réalisé possède les paramètres suivants :
- horloge HF de 1.87 MHz ;
- horloge de transmission de 9600 Hz ;
- code Manchester direct : un bit à "1" est codé par les deux bits "10" ; un bit à "0" est codé par les deux bits "01" ; la durée d'un bit codé Manchester est égale à la moitié de celle d'un bit non codé. La vitesse réelle de transmission est donc de 19200 bauds (par contre un code Manchester indirect code un bit à "1" en "01" et un bit à "0" en "10").

### ANNEXE

### DESCRIPTION EN LANGAGE VHDL

### I - Vue externe codeur/décodeur de l'invention et décomposition en modules

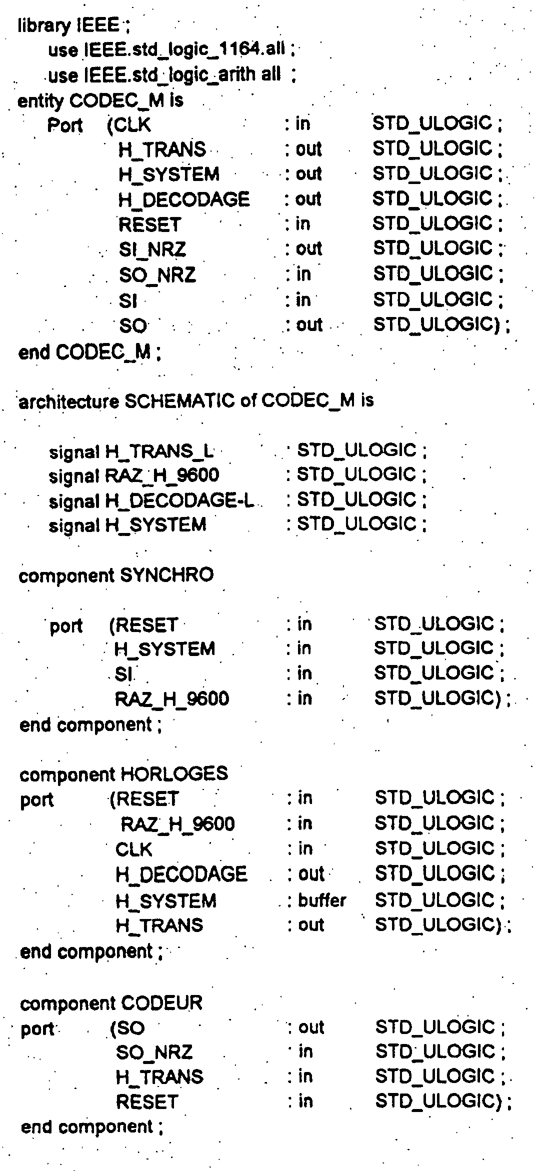

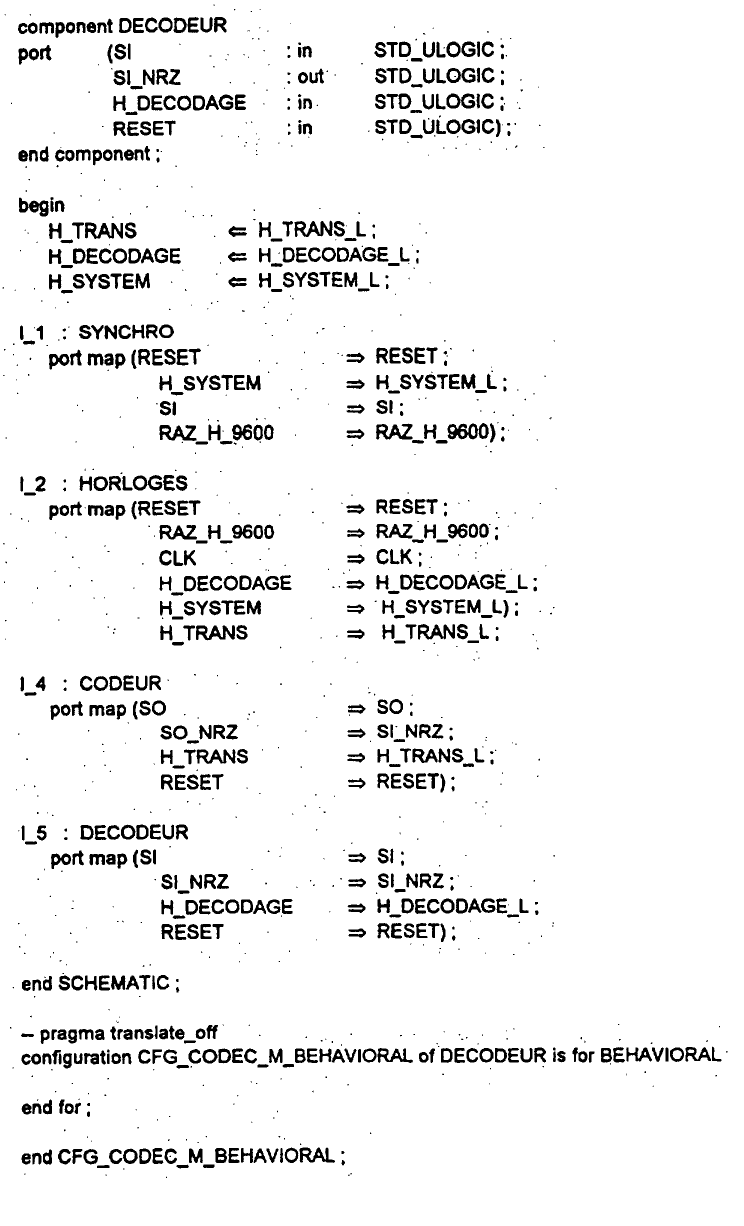

### II - Module (11) de génération du signal de synchronisation

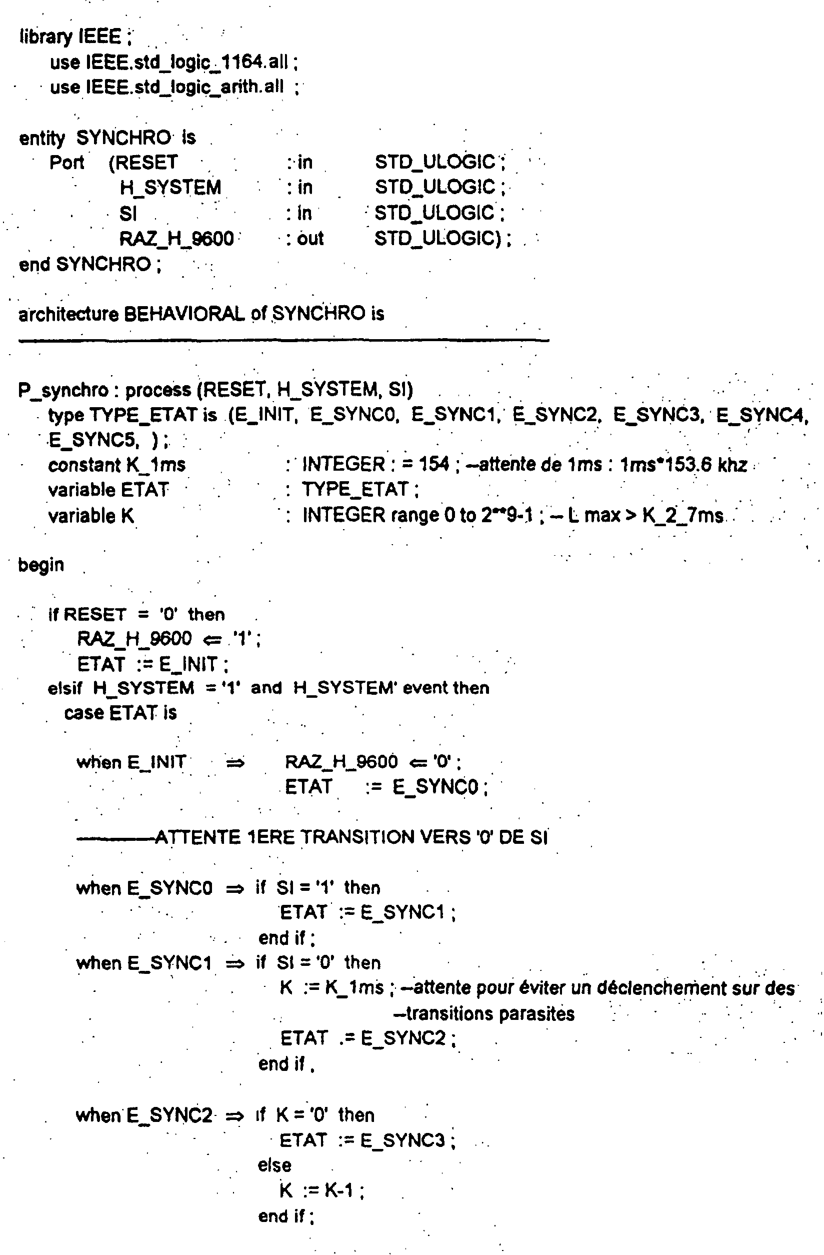

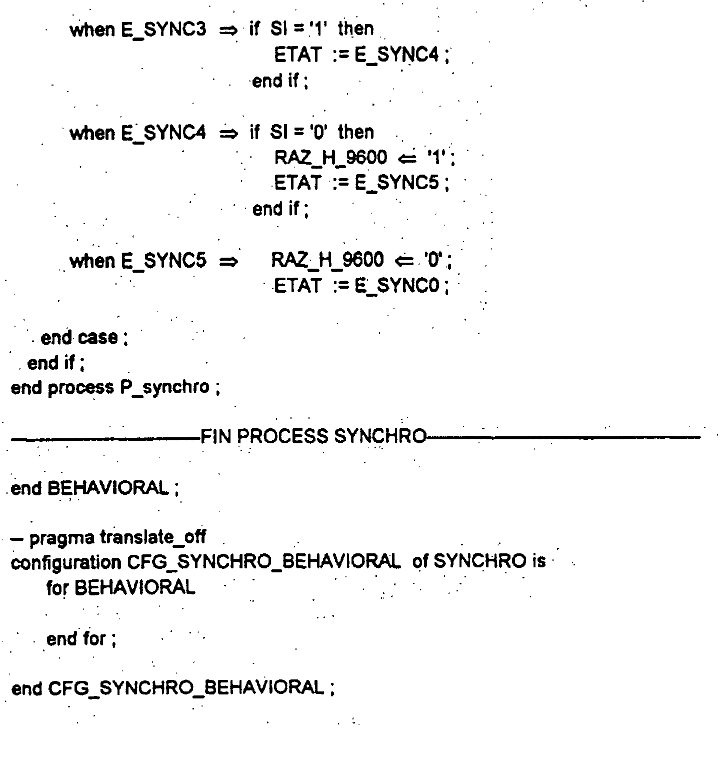

### III - Module (12) de génération des horloges

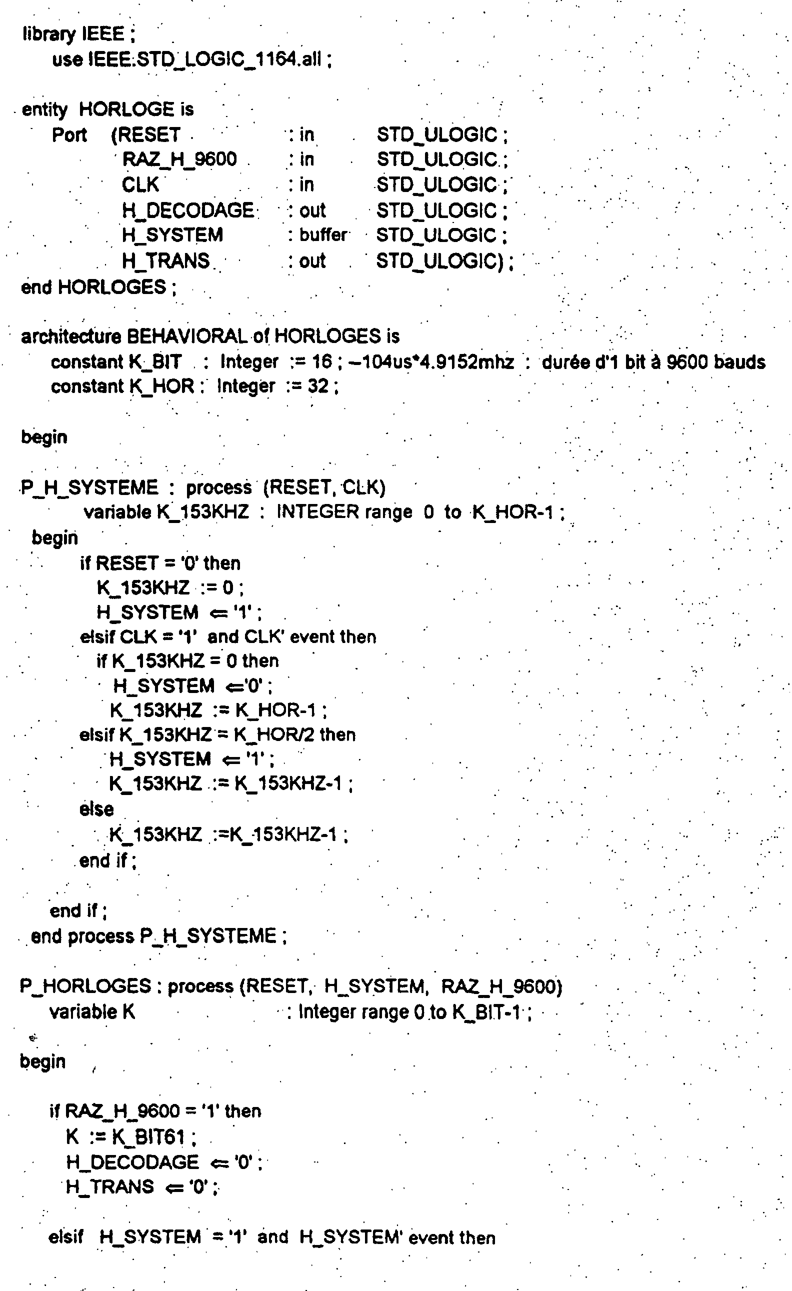

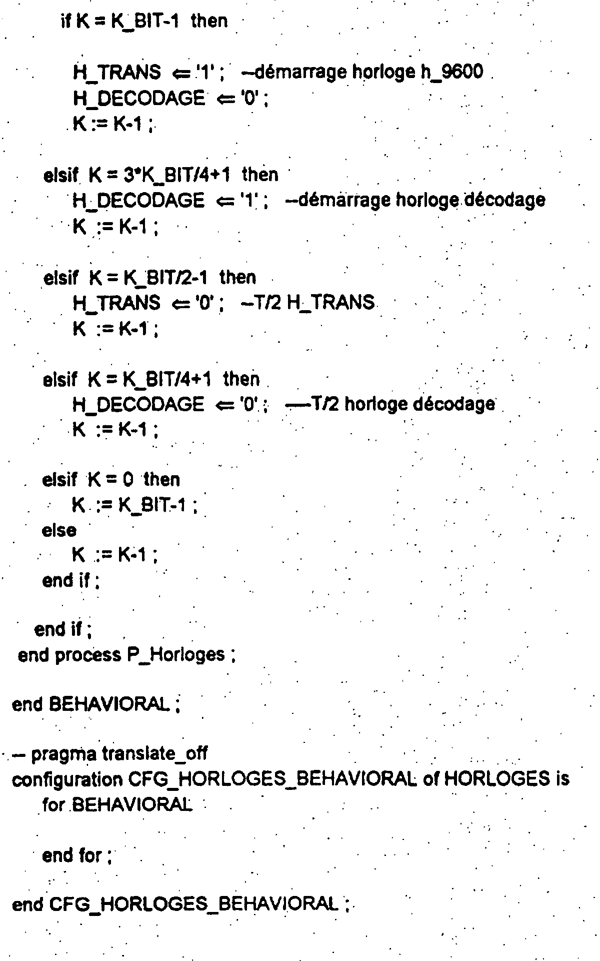

### IV - Module (13) de décodage

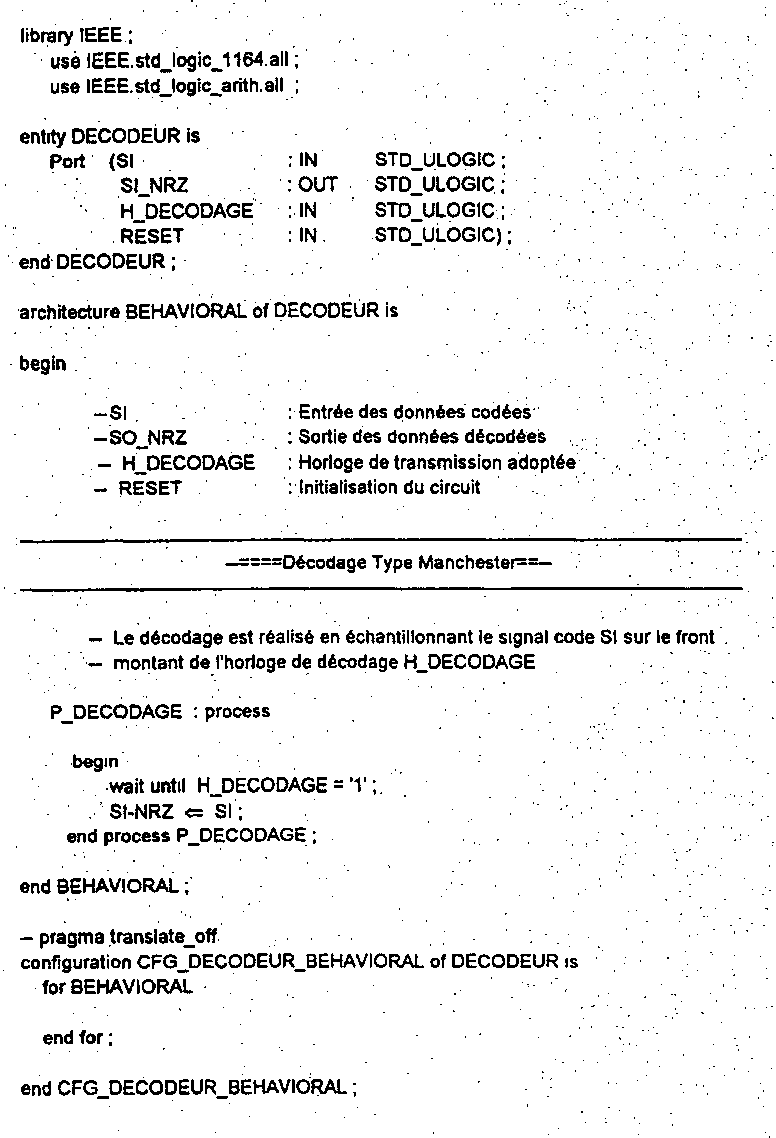

### V - Module (14) de codage

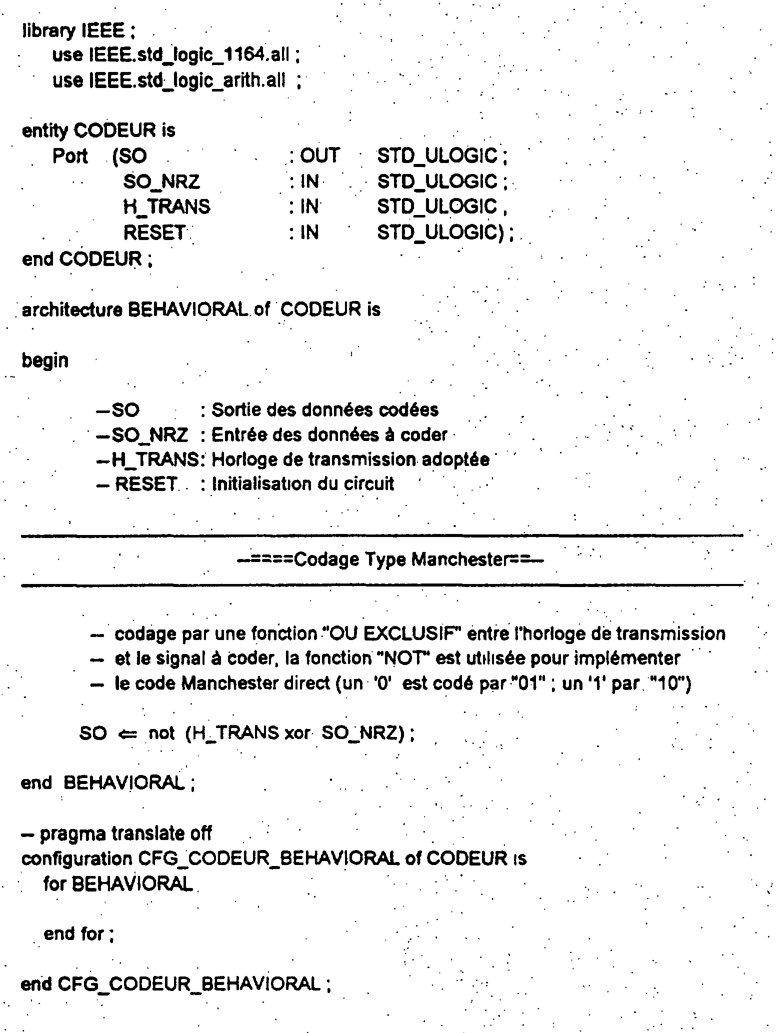

## Revendications

1. Codeur/décodeur Manchester, comprenant les modules suivants :
- un module (11) de génération d'un signal de synchronisation, qui donne le signal de départ des horloges ;
- un module (12) de synchronisation et génération des horloges, qui génère des horloges de transmission/codage, de décodage et une horloge basse fréquence ;
- un module (13) de décodage, qui comprend une bascule pilotée par l'horloge de décodage, le décodage étant un simple échantillonnage du signal d'entrée des données codées Manchester pendant la phase de réception et destinées à être décodées ;
- un module (14) de codage, qui réalise une fonction "OU EXCLUSIF" entre le signal d'entrée des données destinées à être codées en code Manchester pendant la phase d'émission et l'horloge de transmission,
**caractérisé en ce que** ledit codeur/décodeur fonctionne avec l'horloge de codage et l'horloge de décodage à la fréquence de transmission définie, la première horloge étant générée à partir du signal HF reçu en utilisant un diviseur de fréquence, cette horloge étant resynchronisée sur le signal codé lors de la réception, la mise en phase étant effectuée sur un premier front du signal reçu, qui est considéré comme instant zéro pour la création de la seconde horloge, la seconde horloge étant également générée à partir du signal HF reçu, en utilisant le même diviseur de fréquence que celui qui génère l'horloge de codage, cette horloge de décodage présentant un retard déterminé, par rapport à l'horloge de codage.

2. Codeur/décodeur selon la revendication 1, dans lequel ces deux horloges fonctionnent à 9600 bauds.

3. Codeur/décodeur selon la revendication 1, qui est réalisé sous forme d'une macro-cellule intégrée dans un ASIC, qui intègre également la tête analogique, une mémoire et une partie logique qui gère le protocole d'émission/réception et de lecture/écriture dans la mémoire.

4. Utilisation d'un codeur/décodeur selon la revendication 1, sous la forme d'un circuit programmable.

5. Utilisation d'un codeur/décodeur selon la revendication 1, dans le domaine des cartes sans contact.

6. Utilisation d'un codeur/décodeur selon la revendication 1, dans le domaine des étiquettes électroniques.

## Patentansprüche

1. Manchester-Codierer/-Decodierer, der folgende Module umfaßt:
ein Modul (11) zur Erzeugung eines Synchronisiersignals, welches das Startsignal von Taktsignalgebern bzw. Taktsignalen vorgibt,
ein Modul (12) zur Synchronisierung und Erzeugung der Taktsignale, das Übertragungs-/Codier-Taktsignale, Decodier-Taktsignale und ein Niederfrequenz-Taktsignal erzeugt,
ein Modul (13) zur Decodierung, welches eine durch das Decodier-Taktsignal gesteuerte Kippschaltung umfasst, wobei die Decodierung eine einfache Abtastung des Eingangssignals der während der Empfangsphase Manchester-codierten und zur Decodierung bestimmten Daten ist,
ein Modul (14) zur Codierung, welches eine "AUSSCHLIESSENDE ODER"-Funktion zwischen dem Eingangssignal der während der Emissionsphase zur Codierung im Manchester-Code bestimmten Daten und dem Übertragungs-Taktsignal realisiert,
**dadurch gekennzeichnet, dass**
der Codierer/Decodierer mit dem Codier-Taktsignal und dem Decodier-Taktsignal bei der definierten Übertragungsfrequenz arbeitet, wobei das erste Taktsignal ausgehend vom empfangenen HF-Signal unter Verwendung eines Frequenzteilers erzeugt wird, dieses Taktsignal während des Empfangs mit dem codierten Signal resynchronisiert wird, wobei die Phasensynchronisierung an einer ersten Anstiegsflanke des empfangenen Signals vorgenommen wird, welche als Null-Zeitpunkt für die Erzeugung des zweiten Taktsignals betrachtet wird, und das zweite Taktsignal unter Verwendung des gleichen Frequenzteilers wie dem, welcher das Codier-Taktsignal erzeugt, ebenfalls ausgehend von dem empfangenen HF-Signal erzeugt wird, wobei dieses Decodier-Taktsignal im Verhältnis zum Codier-Taktsignal eine bestimmte Verzögerung aufweist.

2. Codierer/Decodierer gemäß Anspruch 1, wobei diese beiden Taktsignalgeber mit 9600 Bauds funktionieren.

3. Codierer/Decodierer gemäß Anspruch 1, der in Form einer Makrozelle realisiert ist, welche in einen ASIC integriert ist, in den auch ein analoger Kopf, ein Speicher und ein Logikteil, welches das Sende-/Empfangs-Protokoll und das Lese-/Schreib-Protokoll in dem Speicher steuert, integriert sind.

4. Verwendung eines Codierers/Decodierers gemäß Anspruch 1 in Form einer programmierbaren Schaltung.

5. Verwendung eines Codierers/Decodierers gemäß Anspruch 1 im Bereich kontaktloser Karten.

6. Verwendung eines Codierers/Decodierers gemäß Anspruch 1 im Bereich elektronischer Etiketten.

## Claims

1. Manchester coder/decoder, including the following modules
- a synchronization signal generation module (11), which gives the clocks' start signal,
- a module (12) for the synchronization and generation of clocks which generate the transmission/coding and decoding clocks and a low frequency clock;
- a decoding module (13), which includes a flip-flop driven by the decoding clock, the decoding being a simple sampling of the input signal of the Manchester coded data which is to be decoded, during the reception phase;
- a coding module (14), which carries out an "OR EXCLUSIVE" function between the input signal in Manchester code, of data to be decoded during the transmission phase, and the transmission clock;
**characterized in that** said coder/decoder functions with a coding clock and a decoding clock at the given transmission frequency, the first clock being generated from the hf signal received using a frequency divider, said clock being resynchronized on the coded signal during reception, the phasing taking place on a first front of the signal received, which is considered as instant zero for the creation of the second clock, said second clock also being generated from the hf signal received using the same frequency divider as that which generates the coding clock, said decoding clock having a given delay compared with the coding clock.

2. Coder/decoder according to claim 1, wherein the two clocks operate at 9600 bauds.

3. Coder/decoder according to claim 1, which is produced in the form of a macro-cell integrated in an ASIC which also integrates the analog head, a memory and a logic section that manages the transmission/reception protocol and the read/write in the memory.

4. Use of a coder/decoder according to claim 1, in the form of a programmable circuit.

5. Use of a coder/decoder according to claim 1, used in the field of nocontact cards.

6. Use of a coder/decoder according to claim 1, which is used in the field of electronic labels.
